# EUROPÄISCHE PATENTSCHRIFT

(11) **EP 2 822 368 B1**
(45) Veröffentlichungstag und Bekanntmachung des Hinweises auf die Patenterteilung: **22.06.2016**
(21) Anmeldenummer: 14163388.3
(22) Anmeldetag: 03.04.2014
(51) Int. Cl.: H05K 3/04, H05K 3/38, G06K 19/077, B41F 16/00, B41F 19/00, H05K 1/03

(54) **Verfahren und Vorrichtung zum Drucken elektrischer oder elektronischer Strukturen mittels Kaltfolientransfer**
Method and device for printing electrical or electronic structures using cold film transfer
Procédé et dispositif destinés à l'impression de structures électriques ou électroniques au moyen de transfert par film à froid

(30) Priorität: 03.05.2013 DE 102013007702
(43) Veröffentlichungstag der Anmeldung: 07.01.2015
(73) Patentinhaber: Heidelberger Druckmaschinen AG, 69115 Heidelberg (DE)
(72) Erfinder: Dr. Schmitt-Lewen, Martin, 69118 Heidelberg (DE); Weber, Alexander, 69469 Weinheim (DE)

(56) Entgegenhaltungen:
- EP-A2- 0 945 280
- DE-A1-102008 047 096
- US-A- 4 091 125

## Beschreibung

Vorliegende Erfindung betrifft ein Verfahren und eine Vorrichtung zum Drucken elektrischer oder elektronischer Strukturen mittels Kaltfolientransfer.

Mittels Kaltfolientransferverfahren können dekorative Beschichtungen, wie Hologramme, und funktionelle Beschichtungen, wie elektrische oder elektronische Strukturen, auf einen Bedruckstoff aufgebracht werden. Elektrische Strukturen sind z. B. elektrische Leiterbahnen. Elektronische Strukturen sind z. B. elektronische Schaltungen. Zum Herstellen der elektronischen oder elektrischen Strukturen umfasst die Kaltfolie eine Transferschicht aus elektrisch halbleitendem oder leitendem Material, wie z. B. Aluminium.

In DE102008047096A1 ist ein Kaltfolientransferverfahren beschrieben, mit dem das optische Erscheinungsbild des Kaltfoliendrucks verbessert werden soll. Es ist erkannt worden, dass die auf den Bedruckstoff übertragene Transferschicht zu Rissbildung neigt. Die Ursache wird in der rauen Oberfläche des Gummituchs des Anpresszylinders gesehen, der die Kaltfolie gegen den Bedruckstoff presst. Als Lösung wird die Verwendung eines Gummituchs mit glatter Oberfläche vorgeschlagen.

In DE102004019412A1 ist ein Kaltfolientransferverfahren zum Drucken elektrischer oder elektronischer Strukturen beschrieben. Das Problem der Rissbildung ist noch nicht erkannt worden. Die die elektrischen oder elektronischen Strukturen auf dem Bedruckstoff bildende Transferschicht würde in der Praxis aber zur Rissbildung neigen. Bei den elektrischen oder elektronischen Strukturen wird durch die Rissbildung nicht lediglich das optische Erscheinungsbild beeinträchtigt, welches hier sowieso nur eine untergeordnete Rolle spielt, sondern vielmehr die stromleitende Funktion. Es besteht z. B. die Gefahr, dass linienförmige Leiterbahnen durch lange, durchgehende Querrisse in der Leiterbahn vollständig unterbrochen werden.

Kaltfolientransferverfahren sind auch in US8136563B2 und US8206527B2 beschrieben.

Der Erfindung liegt die Aufgabe zugrunde, ein weiteres Verfahren und eine weitere Vorrichtung zum Drucken elektrischer oder elektronischer Strukturen mittels Kaltfolientransfer zu schaffen.

Diese Aufgabe wird durch ein Verfahren mit den Merkmalen des Anspruchs 1 und eine Vorrichtung mit den Merkmalen des Anspruchs 7 gelöst. Das erfindungsgemäße Verfahren zum Drucken elektrischer oder elektronischer Strukturen mittels Kaltfolientransfer ist dadurch gekennzeichnet, dass Sollbruchstellen in der Transferschicht erzeugt werden. Die erfindungsgemäße Vorrichtung zum Drucken elektrischer oder elektronischer Strukturen mittels Kaltfolientransfer ist dadurch gekennzeichnet, dass Mittel zum Erzeugen von Sollbruchstellen in der Transferschicht vorhanden sind.
Es werden nicht lediglich Bruchstellen in der Transferschicht erzeugt, sondern Sollbruchstellen. Das Erzeugen der Sollbruchstellen kann ein Vorbestimmen der Positionen und/oder Anzahl und/oder Anordnung und/oder Verteilung und/oder Größe und/oder Form der Sollbruchstellen umfassen.

Die Erfindung hat folgende Vorteile. Durch die Sollbruchstellen wird eine Vielzahl kurzer Risse provoziert, durch welche mechanische Spannungen zwischen dem Bedruckstoff und der darauf übertragenen Transferschicht abgebaut werden. Durch den Abbau der Spannungen können sich keine langen, durchgehenden Querrisse bilden, durch welche die Leiterbahn sonst vollständig unterbrochen würde. Die kurzen Risse sind keine durchgehenden Risse. Durch keinen der kurzen Risse wird die Leiterbahn in Querrichtung vollständig durchtrennt. Deshalb ist in Längsrichtung der meistens linienförmigen Leiterbahn ein ununterbrochener Stromfluss sichergestellt. Hierbei kann der elektrische Strom um die Sollbruchstellen und die davon ausgehenden oder einmündenden kurzen Risse herum mäandern oder sich dazwischen durchschlängeln. Die sogenannte Perkolation des elektrischen Stroms ist auch unter widrigen Umständen, wie z. B. einem besonders stark zu Rissbildung neigendem Material der Transferschicht, sichergestellt. Somit sind die mit dem erfindungsgemäßen Verfahren und der erfindungsgemäßen Vorrichtung hergestellten elektrischen oder elektronischen Strukturen, bei denen es sich z. B. um RFID-Transponder oder Teile davon, wie Antennen, handeln kann, besonders funktionssicher. Das Material der Transferschicht kann halbleitend (z. B. fotoleitend) oder vorzugsweise leitend sein.

Es sind verschiedene Weiterbildungen der Erfindung möglich. Die Sollbruchstellen können von einer Feinstruktur bestimmt werden, mit der eine Kontaktfläche versehen wird, welche die Transferschicht bei deren Transfer auf den Bedruckstoff kontaktiert. Bei der Kontaktfläche kann es sich um die Fläche des Bedruckstoffs selbst oder um die Umfangsfläche eines Transfer- oder Anpresszylinders handeln, welcher die Kaltfolie mitsamt ihrer Transferschicht gegen den Bedruckstoff presst. Ist die Kontaktfläche eine Bedruckstofffläche, kann die Feinstruktur auf die Bedruckstofffläche aufgetragen oder durch Deformation der Bedruckstofffläche erzeugt werden. Die Mittel zum Erzeugen von Sollbruchstellen in der Transferschicht können Mittel zum Erzeugen der Feinstruktur umfassen, wobei die Mittel zum Erzeugen der Feinstruktur Bestandteil einer die Folientransfervorrichtung umfassenden Druckmaschine sein können.

Die Feinstruktur kann eine Vielzahl erhabener Strukturelemente umfassen, welche die Transferschicht punktuell deformieren oder perforieren und dadurch die Bildung der kurzen Risse ermöglichen. Durch die Strukturelemente werden beim Transfer der Transferschicht in dieser Schwächungs- oder Durchstoßstellen erzeugt, die Ausgangs- oder Endpunkte für die Bildung der kurzen Risse sind. Die Strukturelemente können regelmäßig, z. B. als Rasterpunkte, oder unregelmäßig, z. B. als Rauheits-Peaks, verteilt sein. Die in der Transferschicht durch die Strukturelemente erzeugten Deformations- oder Perforationsstellen sind den Strukturelementen entsprechend regulär oder irregulär verteilt.

Bei einer hinsichtlich eines Umrüstens der Druckmaschine von einem auf einen anderen Druckauftrag vorteilhaften Weiterbildung werden die Sollbruchstellen in der Transferschicht durch eine Prägung des Bedruckstoffs erzeugt. Die Prägung kann eine Mikroprägung sein. Die Feinstruktur ist in diesem Fall eine Prägestruktur. Die Mittel zum Erzeugen der Sollbruchstellen in der Transferschicht umfassen hierbei Mittel zum Prägen des Bedruckstoffs, wobei das Prägen vor dem Transfer der Transferschicht auf den Bedruckstoff und vorzugsweise inline innerhalb der Druckmaschine erfolgt. Die Mittel zum Prägen des Bedruckstoffs können z. B. eine Prägeplatte umfassen, die ein der Feinstruktur entsprechendes oder mit dieser komplementäres Prägerelief aufweist. Die Prägeplatte kann auf einen Prägezylinder eines Prägewerks der Druckmaschine aufgespannt sein. Ein Druck- oder Lackierwerk der Druckmaschine kann zu dem Prägewerk umgerüstet werden, z. B., indem ein Gummituch auf einem Gummituchzylinder eines Offsetdruckwerks oder im anderen Fall eine Flexodruckplatte auf dem Lackierzylinder des Lackierwerks durch die Prägeplatte ersetzt wird. Nach der Umrüstung bildet der vormalige Gummituchzylinder oder Lackierzylinder nunmehr den Prägezylinder.

Bei einer Weiterbildung, die hinsichtlich der Verarbeitung eines schlecht prägbaren Bedruckstoffs vorteilhaft ist, werden die Sollbruchstellen in der Transferschicht durch eine Körnung erzeugt. Schlecht prägbar sind z. B. Druckbogen aus harter Kunststofffolie. Die Körnung kann eine Mikrokörnung sein. Die Feinstruktur ist in diesem Fall eine Körnungsstruktur. Die Mittel zum Erzeugen der Sollbruchstellen in der Transferschicht umfassen hierbei Mittel zum Aufbringen der Körnung auf den Bedruckstoff, wobei das Aufbringen der Körnung vor dem Transfer der Transferschicht auf den Bedruckstoff und vorzugsweise inline innerhalb der Druckmaschine erfolgt. Die Mittel zum Aufbringen der Körnung auf den Bedruckstoff können hierbei ein Beschichtungswerk, wie ein Druckwerk oder ein Lackierwerk, umfassen, mit dem eine Körner enthaltende Beschichtungsflüssigkeit auf den Bedruckstoff aufgetragen wird. Die Körner lagern sich auf der Bedruckstoffoberfläche ab und bilden eine Grundierung für die Transferschicht. Beim nachfolgenden Transfer der Transferschicht auf den mit der Körnung versehenen Bereich des Bedruckstoffs wird die Transferschicht von den dort abgelagerten Körnern durchstoßen oder stark gequetscht, wobei die daraus resultierenden Durchstoßstellen oder Quetschstellen in der Transferschicht die Sollbruchstellen als Anfangs- oder Endpunkte der erwünschten, kurzen Risse bilden. Die Beschichtungsflüssigkeit kann ein sogenanntes Mattierungsmittel oder kann jener Kleber sein, der zum Verkleben der Transferschicht mit dem Bedruckstoff sowieso erforderlich ist, und die Körner können Glasperlen oder Glasstaub sein.

Bei einer hinsichtlich des Verzichts auf den Einsatz zusätzlicher Präge- oder Beschichtungswerke vorteilhaften Weiterbildung werden die Sollbruchstellen in der Transferschicht durch einen auf die Transferschicht oder vorzugsweise auf den Bedruckstoff erfolgenden Auftrag jenes Klebers erzeugt, der zum Verkleben der Transferschicht mit dem Bedruckstoff sowieso erforderlich ist. Der Kleberauftrag kann gemäß einem Kleberdruckbild mit einer Kleberrasterung oder -modulation erfolgen. Die Feinstruktur ist in diesem Fall eine Kleberstruktur. Die Mittel zum Erzeugen der Sollbruchstellen in der Transferschicht umfassen hierbei Mittel zum Auftragen des Klebers auf die Transferschicht oder vorzugsweise auf den Bedruckstoff, wobei das Auftragen vor dem Transfer der Transferschicht auf den Bedruckstoff und vorzugsweise inline innerhalb der Druckmaschine erfolgt. Die Mittel zum Auftragen des Klebers auf den Bedruckstoff können z. B. eine Druckplatte umfassen, die eine der Feinstruktur entsprechende Rasterung des Kleberdruckbilds aufweist. Die Kleberdruckplatte kann eine Offsetdruckplatte sein und auf einen Druckformzylinder eines Offsetdruckwerks der Druckmaschine aufgespannt sein.

Der verwendete Kleber kann elektrisch halbleitend (z. B. fotoleitend) oder leitend sein, z. B. durch seine Anreicherung mit Graphit, und dadurch die sogenannte Perkolation des elektrischen Stroms durch die elektrische oder elektronische Struktur unterstützen. Der elektrisch halbleitende oder leitende Kleber überbrückt Risse, die sonst zu einer Unterbrechung des Stromflusses führen würden. Unabhängig von der Erfindung - welche in dem Verfahren zum Drucken elektrischer oder elektronischer Strukturen mittels Kaltfolientransfer, welches dadurch gekennzeichnet ist, dass Sollbruchstellen in der Transferschicht erzeugt werden, besteht - wird eine weitere Erfindung in einem Verfahren zum Drucken elektrischer oder elektronischer Strukturen mittels Kaltfolientransfer, welches dadurch gekennzeichnet ist, dass ein elektrisch halbleitender oder leitender Kleber verwendet wird, gesehen. Besonders vorteilhaft ist eine Kombination der beiden Erfindungen, wobei bei dem Verfahren zum Drucken elektrischer oder elektronischer Strukturen mittels Kaltfolientransfer sowohl Sollbruchstellen in der Transferschicht erzeugt werden als auch ein elektrisch halbleitender oder leitender Kleber verwendet wird.

Bei einer ebenfalls hinsichtlich des Verzichts auf den Einsatz zusätzlicher Präge- oder Beschichtungswerke vorteilhaften Weiterbildung werden die Sollbruchstellen in der Transferschicht durch eine Umfangsflächenstruktur jenes Anpresszylinders erzeugt, der zum Anpressen der Kaltfolie mitsamt der Transferschicht gegen den Bedruckstoff sowieso erforderlich ist. Der Anpresszylinder bildet zusammen mit einem Gegendruckzylinder einen Transferspalt, in welchem die Transferschicht von der übrigen Kaltfolienbahn auf den vorzugsweise bogenförmigen Bedruckstoff übertragen wird. Die Umfangsfläche, welche mit der Umfangsflächenstruktur versehen ist, kann ein Zylinderaufzug sein, wie ein Gummituch oder eine Flexodruckplatte. Die Umfangsflächenstruktur kann eine Rauheit, Rasterung oder ein ähnliches regelmäßiges oder unregelmäßiges Relief oder Oberflächenprofil sein. Die Feinstruktur ist in diesem Fall eine Kontaktflächenstruktur einer mit der Kaltfolie beim Folientransfer in Kontakt kommenden Kontaktfläche, hier der Umfangsfläche des Anpresszylinders. Die Mittel zum Erzeugen der Sollbruchstellen in der Transferschicht umfassen hierbei Mittel zum Anpressen der Kaltfolie gegen den Bedruckstoff, wobei durch das Anpressen der Transfer der Transferschicht auf den Bedruckstoff bewirkt wird.

Weitere funktionell und konstruktiv vorteilhafte Weiterbildungen ergeben sich aus der nachfolgenden Beschreibung von Ausführungsbeispielen und der dazugehörigen Zeichnung, in welcher zeigt:
- Fig. 1: eine mittels eines Kaltfolientransferverfahrens des Standes der Technik gedruckte elektrische Leiterbahn,
- Fig. 2: eine erfindungsgemäß gedruckte elektrische Leiterbahn mit Sollbruchstellen in der Transferschicht,
- Fig. 3: eine Druckmaschine mit einer erfindungsgemäßen Kaltfolientransfervorrichtung mit verschiedenen Mitteln zum Erzeugen der Sollbruchstellen in Fig. 2 und
- Fig. 4a - 4g: verschiedene Gitterstrukturen als in der Druckmaschine in Fig. 3 verwendbare Mittel zum Erzeugen der Sollbruchstellen in Fig. 2.

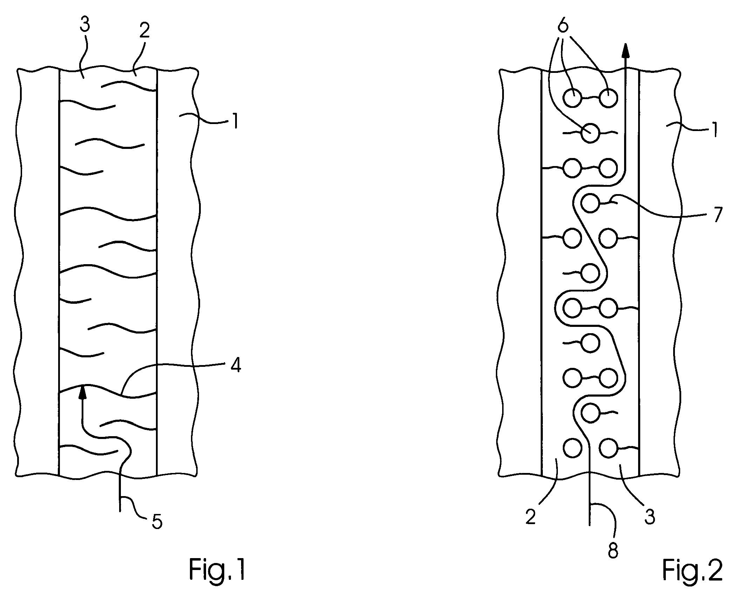

In den Figuren 1 und 2 ist jeweils ein bogenförmiger Bedruckstoff 1, z. B. aus Karton, dargestellt. Auf den Bedruckstoff 1 ist eine Transferschicht 2 als elektrische Leiterbahn 3, z. B. aus Aluminium, mittels Kaltfolientransfer aufgedruckt.

In Figur 1 ist der Stand der Technik dargestellt, wobei die Leiterbahn 3 durch lange Risse 4 vollständig unterbrochen ist, wodurch kein elektrischer Stromdurchfluss durch die Leiterbahn 3 mehr möglich ist, was durch einen Pfeil 5 angedeutet ist, der an einem der langen Risse 4 endet. Ein totaler Funktionsausfall der elektrischen Leiterbahn 3 ist die Folge.

In Figur 2 ist das Druckergebnis der Erfindung dargestellt, wobei die Transferschicht 2 mit Sollbruchstellen 6 versehen ist, welche Ausgangs- und Endpunkte für kurze Risse 7 in der Transferschicht 2 bilden. Die Entstehung der kurzen Risse 7 ist durch die Sollbruchstellen 6 provoziert worden. Da die kurzen Risse 7 kürzer als die langen Risse 4 (in Figur 1) sind, wird die Leiterbahn 3 an keiner Stelle vollständig unterbrochen, so dass in jedem Fall ein Durchfluss des elektrischen Stroms 8 durch die Leiterbahn 3 gesichert ist, der mit einem Pfeil symbolisch angedeutet ist. Der Strom 8 fließt um die kurzen Risse 7 herum. Falls es sich bei den Sollbruchstellen 6 um Durchgangslöcher in der Transferschicht 2 oder Leiterbahn 3 handelt, fließt der Strom auch um die Sollbruchstellen 6 herum, wie dies gezeigt ist. Falls es sich bei den Sollbruchstellen 6 um Quetschstellen in der Transferschicht oder Leiterbahn 3 handeln würde, würde der Strom 8 auch durch die Sollbruchstellen 6 hindurch fließen.

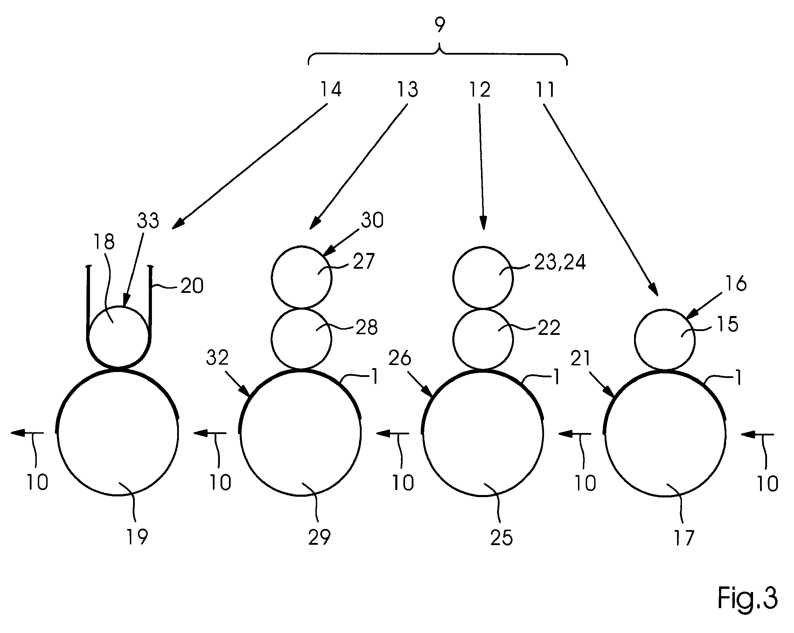

In Figur 3 ist eine Druckmaschine 9 dargestellt, mittels welcher die in Figur 2 ausschnittsweise gezeigte elektrische oder elektronische Struktur auf den Bedruckstoff 1 gedruckt worden ist. Die Druckmaschine 1 hat mehrere Druckwerke für den lithografischen oder planografischen Offsetdruck, die aus Gründen besserer Übersichtlichkeit zeichnerisch nicht mit dargestellt sind. Aus gleichen Gründen sind ein Bogenanleger und ein Bogenausleger der Druckmaschine 9 zeichnerisch nicht mit dargestellt. Der Bedruckstoff 1 durchläuft in einer durch eine Kette von Pfeilen angedeuteten Transportrichtung 10 nacheinander ein Prägewerk 11, ein Vordruckwerk 12, ein Klebewerk 13 und ein Transferwerk 14, welche jeweils ein Mittel zum Erzeugen der Sollbruchstellen 6 enthalten. Zum Erzeugen der Sollbruchstellen 6 können wahlweise nur ein beliebiges oder in Kombination miteinander mehrere beliebige der vorhandenen verschiedenen Mittel zum Erzeugen der Sollbruchstellen 6 verwendet werden, wobei der Bediener die Wahl des oder der Mittel von den Anforderungen des jeweiligen Druckauftrags abhängig machen kann.

Das Prägewerk 11 umfasst einen Prägezylinder 15, dessen Umfangsfläche durch eine aufgespannte Prägeplatte 16 gebildet wird, und einen Gegendruckzylinder 17. Der Gegendruckzylinder 17 bildet zusammen mit dem Prägezylinder 15 einen Prägespalt und transportiert durch diesen hindurch den Bedruckstoff 1. Das Prägewerk 11 ist ein multifunktionell verwendbares Lackierwerk, dessen Lackierzylinder durch das Aufspannen der Prägeplatte 16 zu dem Prägezylinder 15 umgerüstet ist. Die Prägeplatte 16 ist ein Mittel zum Erzeugen der Sollbruchstellen 6 und ein Mittel zum Erzeugen einer Feinstruktur auf dem Bedruckstoff 1 und hat als Prägewerkzeuge punktförmige Prägevorsprünge, die in einem Zufallsmuster angeordnet sind und sich beim Prägen in den Bedruckstoff 1 eindrücken und diesen dadurch mit einer Oberflächentextur oder einem Mikrorelief 21 versehen, das die Feinstruktur bildet.

Das Transferwerk 14 umfasst einen Anpresszylinder 18 und einen Gegendruckzylinder 19, der zusammen mit dem Anpresszylinder 18 einen Transferspalt bildet und durch letzteren hindurch den Bedruckstoff 1 fördert. In dem Transferspalt wird durch den Anpresszylinder 18 eine Kaltfolienbahn 20 gegen den geförderten Bedruckstoff 1 gepresst. Die Kaltfolienbahn 20 umschlingt dabei den Anpresszylinder 18. Die Kaltfolienbahn 20 besteht aus einer Trägerschicht und der Transferschicht und gegebenenfalls einer Trennschicht zwischen der Trägerschicht und der Transferschicht. In dem Transferspalt werden Stücke der Transferschicht von der Trägerschicht abgelöst und aus der restlichen, nicht übertragenen Transferschicht herausgerissen und auf eine Fläche des Bedruckstoffs 1 übertragen. Diese Fläche ist in dem Klebewerk 13 vorher mit Kleber spot-beschichtet worden, damit die Stücke darauf kleben bleiben. Die übertragenen Stücke der Transferschicht 2 bilden nach der Übertragung die Leiterbahnen 3 (vgl. Figur 2). Aus Gründen zeichnerischer Vereinfachung nicht mit dargestellt sind eine Folienvorrats- oder Abwickelrolle und eine Restfolien- oder Aufwickelrolle für die Kaltfolienbahn 20, welche beiden Wickelrollen Bestandteile eines Folienmoduls sind. Das Folienmodul ist auf ein Offsetdruckwerk der Druckmaschine 9 montiert, um dieses zu dem Transferwerk 14 umzurüsten. Vor der Umrüstung fungierte der Anpresszylinder 18 als Gummituchzylinder des Offsetdruckwerks.

Bei der Übertragung der Stücke der Transferschicht 2 auf die mit dem Mikrorelief 21 versehene und danach mit Kleber beschichtete Fläche des Bedruckstoffs 1 stechen, stanzen und/oder quetschen, prägen die Peaks des Mikroreliefs 21 die Sollbruchstellen 6 in die Stücke der Transferschicht 2 hinein, wenn das Mikrorelief 21 ein positives ist. Ist es dagegen ein negatives Mikrorelief 21, hat es statt der Peaks Gruben oder Senken, in deren Bereich die Klebkraft verringert ist und infolgedessen keine Transferschicht übertragen wird, um die Sollbruchstellen 6 zu erzeugen.

Das Vordruckwerk 12 ist ein Flexodruckwerk und umfasst einen Formzylinder 22 und ein zugeordnetes Farbwerk 23 mit einer Rasterwalze 24. Das Farbwerk 23 ist ein Mittel zum Erzeugen der Sollbruchstellen 6 und ein Mittel zum Erzeugen einer Feinstruktur auf dem Bedruckstoff 1 und führt dazu eine Farbe oder vergleichbare Beschichtungsflüssigkeit. Die Beschichtungsflüssigkeit enthält Mikrokörner und bildet mit diesen eine Suspension. Die Rasterwalze 24 trägt die Suspension auf den Formzylinder 22 auf, welcher zusammen mit einem Gegendruckzylinder 25 einen Druckspalt bildet, durch welchen der Gegendruckzylinder 25 den Bedruckstoff 1 transportiert. In dem Druckspalt wird die Suspension von dem Formzylinder 22 auf den transportierten Bedruckstoff 1 aufgetragen. Bestandteile der auf den Bedruckstoff 1 aufgetragenen Beschichtungsflüssigkeit oxidieren, polymerisieren, verdunsten und/oder schlagen weg, so dass nach dieser gegebenfalls durch Strahlung (z. B. UV- oder IR- Strahlung) eines Trockners unterstützten Trocknung die Mikrokörner eine auf dem Bedruckstoff 1 haftende, raue Granulatschicht 26 bilden. Diese Granulatschicht 26 ist die Feinstruktur und die Körner, aus denen die Granulatschicht 26 besteht, sind Peaks oder erhabene Strukturelemente der Feinstruktur.

Bei der danach im Transferwerk 14 erfolgenden Übertragung der Stücke der Transferschicht 2 auf die mit der Granulatschicht 26 versehene und danach mit Kleber beschichtete Fläche des Bedruckstoffs 1 stechen, stanzen und/oder quetschen, prägen die Peaks der Granulatschicht 26 die Sollbruchstellen 6 in die Stücke der Transferschicht 2 hinein.

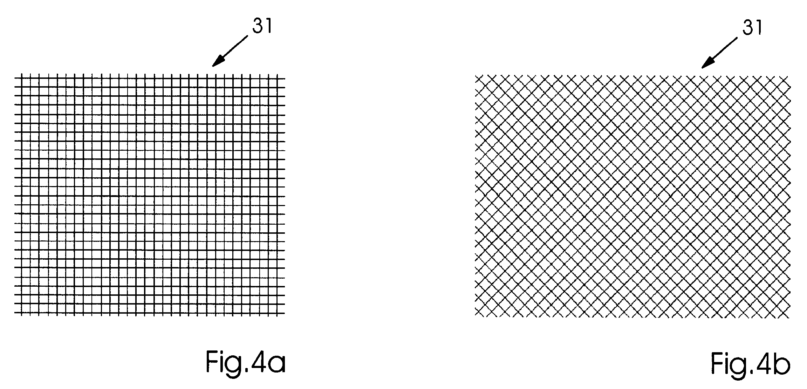

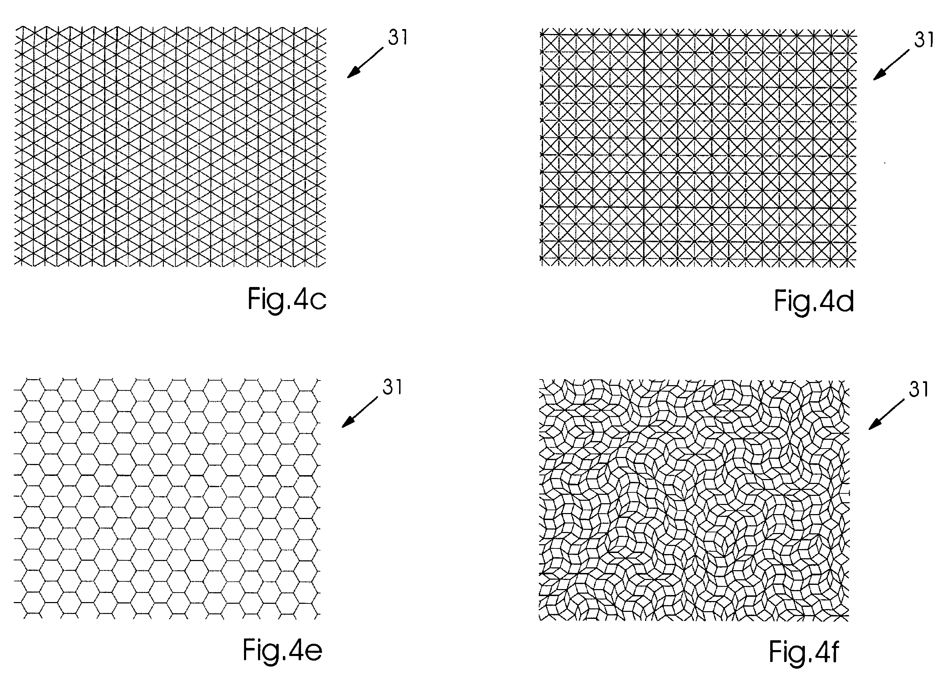

Das Klebewerk 13 ist ein Offsetdruckwerk und umfasst einen Formzylinder 27, einen Gummituchzylinder 28 und einen Gegendruckzylinder 29, der mit dem Gummituchzylinder 29 zusammen einen Druckspalt bildet und den Bedruckstoff 1 durch den Druckspalt hindurch transportiert. Ein den Kleber auf den Formzylinder 27 aufbringendes Farbwerk ist aus Gründen besserer Übersichtlichkeit zeichnerisch nicht mit dargestellt. Eine Umfangsfläche des Formzylinders 27 wird durch eine Druckplatte 30 gebildet, die auf den Formzylinder 27 aufgespannt ist. Die Druckplatte 30 ist eine planografische Druckplatte und hat eine der elektrischen oder elektronischen Struktur mit der Leiterbahn 3 entsprechende Bebilderung, welche zumindest im Bereich der Leiterbahn 3 ein Raster aus Rasterpunkten oder ein Gittermuster 31 (vgl. Figuren 4a bis 4g) aus Linien aufweist. Die Druckplatte 30 ist ein Mittel zum Erzeugen der Sollbruchstellen 6 und ein Mittel zum Erzeugen einer Feinstruktur auf dem Bedruckstoff 1. Das Raster kann ein analoges 34er-Raster oder ein frequenzmoduliertes Raster (sog. FM-Raster) mit einer Flächendeckung im Bereich von 75% bis 90% sein. Bei einem derartigen FM-Raster wird die Klebermenge oder -verteilung leicht moduliert und infolgedessen schwankt die Klebkraft der Modulation folgend in erwünschter Weise. Ist die Druckplatte 30 mit einem Halbtonraster mit einer Flächendeckung im Bereich von 65% bis 90% oberhalb des sogenannten zweiten Punktschlusses versehen, ergibt sich daraus eine gitterartige Struktur der verdruckten Kleberschicht und der daraus resultierenden Anordnung der Sollbruchstellen 6. Der Kleber wird von der Druckplatte 30 über den Gummituchzylinder 28 auf den Bedruckstoff 1 übertragen, auf welchem er ein mit dem Raster oder der Gitterstruktur 31 korrespondierendes Kleberdruckbild 32 bildet. Das Kleberdruckbild 32 bildet besagte Feinstruktur und hat den Rasterpunkten oder Gitterlinien der Druckplatte 30 entsprechende Kleberpunkten bzw. Kleberlinien.

Bei der danach im Transferwerk 14 erfolgenden Übertragung der Stücke der Transferschicht 2 auf die mit dem Kleberdruckbild 32 versehene Fläche des Bedruckstoffs 1 werden in den Positionen der zu erzeugenden Sollbruchstellen 6 keine Stücke der Transferschicht 2 aus der Kaltfolienbahn 20 herausgerissen und auf den Bedruckstoff 1 übertragen, weil in diesen Positionen die lokale Klebermenge nicht ausreicht, um die zum Herausreißen notwendige Haftkraft zwischen Transferschicht 2 und Bedruckstoff 1 zu erzeugen. Besagte Positionen können Kleberpunkte oder Kleberlinien sein, die einen kleineren Durchmesser oder eine kleinere Breite als benachbarte Kleberpunkte oder Kleberlinien mit zum Herausreißen hinreichender Haftkraft haben. Besagte Positionen können auch vom Kleber freie Zwischenräume zwischen den Kleberpunkten oder den Kleberlinien sein.

Das Transferwerk 14 enthält Mittel zum Erzeugen der Sollbruchstellen 6, welche Mittel durch eine Umfangsfläche 33 des Anpresszylinders 18 gebildet werden. Die Umfangsfläche 33 kann durch einen Zylinderaufzug, der z. B. einer Flexodruckform ähnlich ist, gebildet werden und ist mit einer Rasterung versehen, die erhabene Rasterelemente aufweist. Bei der im Transferwerk 14 erfolgenden Übertragung der Stücke der Transferschicht 2 auf die mit dem Kleber beschichtete Fläche des Bedruckstoffs 1 stechen, stanzen und/oder quetschen, prägen die erhabenen Rasterelemente der Umfangsfläche 33 durch die Trägerschicht und - wenn vorhanden - die Trennschicht der Kaltfolienbahn 20 hindurch die Sollbruchstellen 6 in die Stücke der Transferschicht 2 hinein. Die Umfangsfläche 33 kann für diesen Zweck anstelle der Rasterung auch eine Rauheit mit Peaks zum von der Folienrückseite her erfolgenden Stanzen oder Prägen der Transferschichtstücke aufweisen.

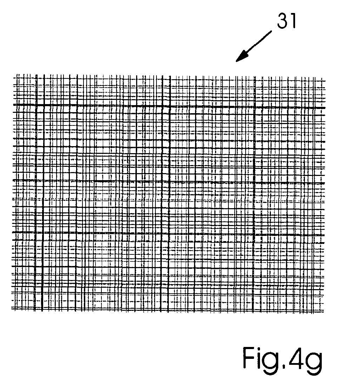

In den Figuren 4a bis 4g sind verschiedene Varianten des bereits erwähnten Gittermusters 31 abgebildet. Figuren 4a und 4b zeigen reguläre Rechteckgitter, Figuren 4c bis 4e zeigen reguläre Gitter, Figur 4f zeigt ein sogenanntes pseudosymmetrisches Gitter und Figur 4g zeigt ein irreguläres Rechteckgitter. In den Figuren 4a bis 4g ist jeweils ein sogenanntes zusammenhängendes Gitter gezeigt.

### Bezugszeichenliste

- 1: Bedruckstoff
- 2: Transferschicht
- 3: Leiterbahn
- 4: langer Riss
- 5: Pfeil
- 6: Sollbruchstelle
- 7: kurzer Riss
- 8: Strom
- 9: Druckmaschine
- 10: Transportrichtung
- 11: Prägewerk
- 12: Vordruckwerk
- 13: Klebewerk
- 14: Transferwerk
- 15: Prägezylinder
- 16: Prägeplatte
- 17: Gegendruckzylinder
- 18: Anpresszylinder
- 19: Gegendruckzylinder
- 20: Kaltfolienbahn
- 21: Mikrorelief
- 22: Formzylinder
- 23: Farbwerk
- 24: Rasterwalze
- 25: Gegendruckzylinder
- 26: Granulatschicht
- 27: Formzylinder
- 28: Gummituchzylinder
- 29: Gegendruckzylinder
- 30: Druckplatte
- 31: Gittermuster
- 32: Kleberdruckbild
- 33: Umfangsfläche

## Patentansprüche

1. Verfahren zum Drucken elektrischer oder elektronischer Strukturen mittels Kaltfolientransfer,
**dadurch gekennzeichnet,**
**dass** Sollbruchstellen (6) in der Transferschicht (2) erzeugt werden.

2. Verfahren nach Anspruch 1,
**dadurch gekennzeichnet,**
**dass** die Sollbruchstellen (6) von einer Feinstruktur bestimmt werden, mit der eine Kontaktfläche versehen wird, welche die Transferschicht (2) bei deren Transfer auf den Bedruckstoff (1) kontaktiert.

3. Verfahren nach Anspruch 1 oder 2,
**dadurch gekennzeichnet,**
**dass** die Sollbruchstellen (6) in der Transferschicht (2) durch eine Prägung des Bedruckstoffs (1) erzeugt werden.

4. Verfahren nach Anspruch 1 oder 2,
**dadurch gekennzeichnet,**
**dass** die Sollbruchstellen (6) in der Transferschicht (2) durch eine Körnung erzeugt werden.

5. Verfahren nach Anspruch 1 oder 2,
**dadurch gekennzeichnet,**
**dass** die Sollbruchstellen (6) in der Transferschicht (2) durch einen Auftrag jenes Klebers erzeugt werden, mit welchem die Transferschicht (2) mit dem Bedruckstoff (1) verklebt wird.

6. Verfahren nach Anspruch 1 oder 2,
**dadurch gekennzeichnet,**
**dass** die Sollbruchstellen (6) in der Transferschicht (2) durch eine Umfangsflächenstruktur jenes Anpresszylinders (18) erzeugt werden, mit welchem die Kaltfolie mitsamt der Transferschicht (2) an den Bedruckstoff (1) gepresst wird.

7. Vorrichtung zum Drucken elektrischer oder elektronischer Strukturen mittels Kaltfolientransfer ist,
**dadurch gekennzeichnet,**
**dass** Mittel zum Erzeugen von Sollbruchstellen (6) in der Transferschicht (2) vorhanden sind.

8. Vorrichtung nach Anspruch 7,
**dadurch gekennzeichnet,**
**dass** die Mittel zum Erzeugen von Sollbruchstellen (6) in der Transferschicht (2) Mittel zum Erzeugen einer Feinstruktur umfassen.

9. Vorrichtung nach Anspruch 7 oder 8,
**dadurch gekennzeichnet,**
**dass** die Mittel zum Erzeugen der Sollbruchstellen (6) in der Transferschicht (2) Mittel zum Prägen des Bedruckstoffs (1) umfassen.

10. Vorrichtung nach Anspruch 7 oder 8,
**dadurch gekennzeichnet,**
**dass** die Mittel zum Erzeugen der Sollbruchstellen (6) in der Transferschicht (2) Mittel zum Aufbringen einer Körnung auf den Bedruckstoff (1) umfassen.

11. Vorrichtung nach Anspruch 7 oder 8,
**dadurch gekennzeichnet,**
**dass** die Mittel zum Erzeugen der Sollbruchstellen (6) in der Transferschicht (2) Mittel zum Auftragen eines Klebers umfassen.

12. Vorrichtung nach Anspruch 7 oder 8,
**dadurch gekennzeichnet,**
**dass** die Mittel zum Erzeugen der Sollbruchstellen (6) in der Transferschicht (2) Mittel zum Anpressen der Kaltfolie gegen den Bedruckstoff (1) umfassen.

## Claims

1. Method for printing electric or electronic structures by means of cold-foil transfer,
**characterized in**
**that** desired breaking points (6) are created in the transfer layer (2).

2. Method according to claim 1,
**characterized in**
**that** the desired breaking points (6) are determined by a fine structure that is provided to a contact surface in contact with the transfer layer (2) upon the transfer thereof to the printing material (1).

3. Method according to claim 1 or 2,
**characterized in**
**that** the desired breaking points (6) are created in the transfer layer (2) by an embossment of the printing material (1).

4. Method according to claim 1 or 2,
**characterized in**
**that** the desired breaking points (6) in the transfer layer are created by granules.

5. Method according to claim 1 or 2,
**characterized in**
**that** the desired breaking points (6) in the transfer layer are created by applying the adhesive that glues the transfer layer (2) and the printing substrate (1) to one another.

6. Method according to claim 1 or 2,
**characterized in**
**that** the desired breaking points (6) in the transfer layer (2) are created by a circumferential surface structure of the pressure cylinder (18) that presses the cold foil including the transfer layer (2) onto the printing material (1).

7. Device for printing electric or electronic structures by means of cold-foil transfer,
**characterized in**
**that** means for creating desired breaking points (6) in the transfer layer (2) are present.

8. Device according to claim 7,
**characterized in**
**that** the means for creating desired breaking points (6) in the transfer layer (2) comprise means for creating a fine structure.

9. Device according to claim 7 or 8,
**characterized in**
**that** the means for creating the desired breaking points (6) in the transfer layer (2) comprise means for embossing the printing material (1).

10. Device according to claim 7 or 8,
**characterized in**
**that** the means for creating the desired breaking points (6) in the transfer layer (2) are means for applying granules to the printing material (1).

11. Device according to claim 7 or 8,
**characterized in**
**that** the means for creating the desired breaking points (6) in the transfer layer (2) comprise means for applying an adhesive.

12. Device according to claim 7 or 8,
**characterized in**
**that** the means for creating the desired breaking points (6) in the transfer layer (2) comprise means for pressing the cold foil against the printing material (1).

## Revendications

1. Procédé pour l'impression de structures électriques et électroniques au moyen de transfert de films à froid,
**caractérisé en ce**
**que** des points de rupture théoriques (6) sont générés dans la couche de transfert (2).

2. Procédé selon la revendication 1,
**caractérisé en ce**
**que** les points de rupture théoriques (6) sont définis par une structure fine qui doit être munie d'une surface de contact qui entre en contact avec la couche de transfert (2) lors de son transfert sur le support imprimé (1).

3. Procédé selon la revendication 1 ou 2,
**caractérisé en ce**
**que** les points de rupture théoriques (6) sont générés dans la couche de transfert (2) par un marquage du support imprimé (1) .

4. Procédé selon la revendication 1 ou 2,
**caractérisé en ce**
**que** les points de rupture théoriques (6) sont générés dans la couche de transfert (2) par une granulation.

5. Procédé selon la revendication 1 ou 2,
**caractérisé en ce**
**que** les points de rupture théoriques (6) sont générés dans la couche de transfert (2) par application d'un adhésif qui permet de coller la couche de transfert (2) au support imprimé (1).

6. Procédé selon la revendication 1 ou 2,
**caractérisé en ce**
**que** les points de rupture théoriques (6) sont générés dans la couche de transfert (2) par une structure de surface périphérique de chaque cylindre presseur (18) qui presse le film

7. Dispositif pour l'impression de structures électriques ou électroniques au moyen de transfert de films à froid,
**caractérisé en ce**
**que** des moyens pour la réalisation de points de rupture théoriques (6) sont prévus dans la couche de transfert (2).

8. Dispositif selon la revendication 7,
**caractérisé en ce**
**que** des moyens pour la réalisation de points de rupture théoriques (6) dans la couche de transfert (2) comprennent des moyens pour la réalisation d'une fine structure.

9. Dispositif selon la revendication 7 ou 8,
**caractérisé en ce**
**que** des moyens pour la réalisation de points de rupture théoriques (6) dans la couche de transfert (2) comprennent des moyens pour le marquage sur le support imprimé (1).

10. Dispositif selon la revendication 7 ou 8,
**caractérisé en ce**
**que** des moyens pour la réalisation de points de rupture théoriques (6) dans la couche de transfert (2) comprennent des moyens pour l'application d'une granulation sur le support imprimé (1).

11. Dispositif selon la revendication 7 ou 8,
**caractérisé en ce**
**que** des moyens pour la réalisation de points de rupture théoriques (6) dans la couche de transfert (2) comprennent des moyens pour l'application d'un adhésif.

12. Dispositif selon la revendication 7 ou 8,
**caractérisé en ce**
**que** des moyens pour la réalisation de points de rupture théoriques (6) dans la couche de transfert (2) comprennent des moyens pour le pressage du film à froid sur le support imprimé (1).
